(19) Europäisches Patentamt
European Patent Office
Office européen des brevets

(11) **EP 3 325 922 B1**

(12) **FASCICULE DE BREVET EUROPEEN**

(45) Date de publication et mention
de la délivrance du brevet:
**04.09.2019 Bulletin 2019/36**

(21) Numéro de dépôt: **16748337.9**

(22) Date de dépôt: **13.07.2016**

(51) Int Cl.:
***G01D 5/245*** *(2006.01)*   ***G01D 5/14*** *(2006.01)*
***G01B 7/00*** *(2006.01)*   ***G01R 33/06*** *(2006.01)*

(86) Numéro de dépôt international:
**PCT/FR2016/051810**

(87) Numéro de publication internationale:
**WO 2017/013333 (26.01.2017 Gazette 2017/04)**

(54) **CAPTEUR DE MESURE DE LA POSITION ABSOLUE D'UN MOBILE**

SENSOR ZUR MESSUNG DER ABSOLUTEN POSITION EINES BEWEGBAREN TEILS

SENSOR FOR MEASURING THE ABSOLUTE POSITION OF A MOVING PART

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **21.07.2015 FR 1556911**

(43) Date de publication de la demande:
**30.05.2018 Bulletin 2018/22**

(73) Titulaire: **Electricfil Automotive
01700 Miribel Cedex (FR)**

(72) Inventeurs:
• **MÖLLER, Rainer**
**69970 Chaponnay (FR)**
• **LE NY, Mathieu**
**69100 Villeurbanne (FR)**

(74) Mandataire: **Cabinet Beau de Loménie
51 avenue Jean Jaurès
BP 7073
69301 Lyon Cedex 07 (FR)**

(56) Documents cités:
**WO-A1-2014/131434     US-A1- 2008 024 122**

**Description**

La présente invention concerne le domaine technique des capteurs de mesure permettant de déterminer la position absolue d'un mobile se déplaçant selon une trajectoire circulaire, linéaire ou curviligne.

L'objet de l'invention présente de nombreuses applications et en particulier dans le domaine de l'automobile pour mesurer avec précision par exemple la position angulaire d'un arbre à cames ou du vilebrequin ou la position linéaire du sélecteur de vitesse dans une boite de vitesse automatique.

L'état de la technique a proposé de nombreuses solutions techniques pour déterminer la position absolue d'un mobile.

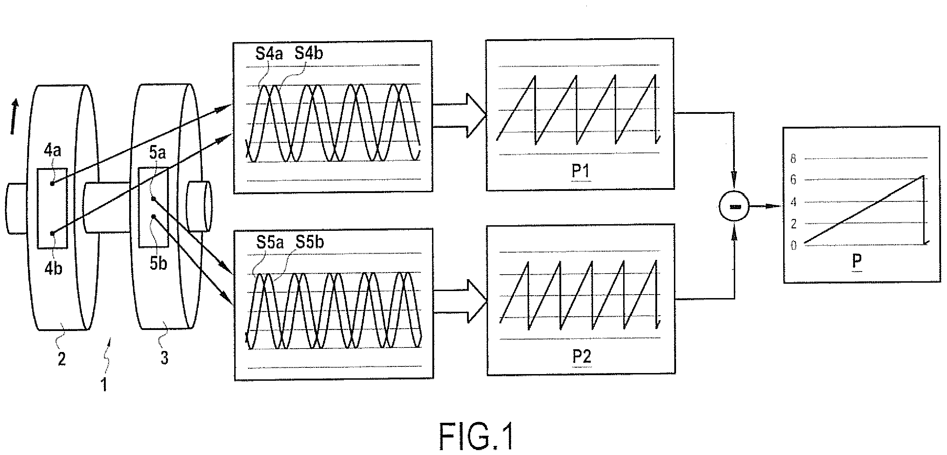

Par exemple, la demande de brevet WO 01142753 décrit un capteur de mesure comportant une série de sondes de détection d'une grandeur physique provenant de deux cibles montées solidaires du mobile **1** dont la position est à mesurer. Typiquement et comme illustré à la **Fig. 1**, la grandeur physique à mesurer est un champ magnétique produit par deux cibles magnétiques **2, 3** dont l'une présente un nombre de pôles magnétiques différent du nombre de pôles de l'autre piste. Chaque cible **2, 3** est réalisée de manière à ce que le champ magnétique mesuré par les sondes de détection varie de manière sinusoïdale selon la trajectoire de déplacement avec une périodicité qui diffère entre les deux cibles. Deux sondes de mesure **4a, 4b** et **5a, 5b** sont placées en face de chaque cible respectivement **2, 3** en étant décalées entre elles selon la trajectoire de déplacement de manière à générer, pour chaque cible, deux signaux sinusoïdaux déphasés entre eux d'un quart de période, **S4a, S4b** et **S5a, S5b**. De tels signaux sinusoïdaux sont soumis à un traitement trigonométrique permettant de déterminer pour chaque cible, la position relative **P1, P2** du mobile à l'intérieur d'une période. La différence entre les positions relatives **P1, P2** du mobile, obtenues pour chaque cible permet de déterminer la position absolue **P** du mobile. Cette méthode de mesure est connue sous le nom de méthode vernier ou méthode modifiée vernier.

Une telle méthode de mesure est également décrite par la demande de brevet WO 2014/131434.

Le capteur de mesure décrit par cette demande de brevet nécessite la mise en oeuvre de deux cibles et de deux détecteurs comportant chacun deux sondes de mesure espacées d'une valeur égale à la longueur d'onde divisée par 4. Dans la mesure où la longueur d'onde est différente pour les deux pistes, un tel capteur nécessite un détecteur spécifique pour chaque cible. Aussi la distance entre les deux cibles doit être suffisamment grande pour limiter la diaphonie. Outre un problème de coût, un tel capteur de mesure pose un problème d'encombrement qui s'avère rédhibitoire dans des applications pour lesquels la place disponible pour le montage du capteur de mesure est très réduite.

La demande de brevet EP 2 385 353 décrit un capteur de mesure comportant une piste magnétique constituée de pôles magnétiques dont la largeur est modulée de manière à obtenir un signal comportant une composante haute fréquence correspondant à la périodicité des paires de pôles et une composante basse fréquence correspondant à une période par tour mécanique de la cible. La détection d'un tel signal magnétique est assurée par deux sondes de mesure disposées à proximité l'une de l'autre. La somme et la différence des signaux délivrés par ces sondes sont calculées pour permettre de déterminer la position du mobile.

Il est à noter que le signal magnétique généré par une telle piste magnétique contient, à faible entrefer, une distorsion harmonique importante (multiple de la période des paires de pôles) ayant pour conséquence de dégrader la précision de la mesure. Pour un fort entrefer, la distorsion harmonique est moins importante mais l'amplitude du signal magnétique est plus faible, ce qui conduit à dégrader la précision de la mesure. Par ailleurs, le signal différentiel contient encore une partie non négligeable du signal de modulation, ce qui altère aussi la précision de mesure. Enfin, les signaux obtenus avec deux sondes de mesure ne permettent pas de déterminer la position absolue de manière univoque à l'arrêt du mobile. Pour remédier à ce problème, ce document propose d'ajouter une troisième sonde de mesure positionnée à 90° par rapport aux deux autres. Outre un problème de coût, cette solution pose un problème d'encombrement.

Il est également connu par la demande de brevet US 2008/024122, un capteur de mesure pour déterminer la position d'un mobile se déplaçant selon une trajectoire déterminée. Ce capteur comporte au moins quatre sondes de détection d'une grandeur physique provenant d'une cible montée solidaire du mobile. Cette cible émet un signal pseudo-sinusoïdal variant en fonction de la position de la cible. Un tel capteur comporte des moyens de combinaison linéaire des signaux délivrés par les sondes de manière à former deux signaux pseudo-sinusoïdaux en quadrature et de même amplitude. Un tel capteur ne permet pas de mesurer avec grande précision la position absolue d'un mobile.

L'objet de la présente invention vise à remédier aux inconvénients des solutions antérieures en proposant un capteur permettant de mesurer avec une grande précision, la position absolue d'un mobile et adapté pour pouvoir être installé dans un volume limité tout en présentant un coût réduit.

Pour atteindre un tel objectif, le capteur de mesure selon l'invention vise à mesurer la position d'un mobile se déplaçant selon une trajectoire déterminée, le capteur comportant une série d'au moins quatre sondes de détection d'une grandeur physique provenant d'une cible montée solidaire du mobile, la cible comportant au moins une piste de création d'une grandeur physique mesurable par les sondes de détection, variant selon la trajectoire de la cible selon une fonction continue et comportant un premier harmonique et un deuxième harmonique, les sondes étant reliées à une unité de traitement des signaux délivrés par les sondes, comportant un système de reconstruction, permettant d'assurer une combinaison linéaire des signaux délivrés par les sondes de détection et d'obtenir à partir de la combinaison linéaire de ces signaux, au moins d'une part, deux signaux en quadrature comportant uniquement le premier harmonique et d'autre part, deux signaux en quadrature comportant uniquement le deuxième harmonique, l'unité comportant également un système de calcul assurant le traitement des signaux en quadrature pour déterminer la position du mobile.

De plus, le capteur selon l'invention peut présenter en outre en combinaison au moins l'une et/ou l'autre des caractéristiques additionnelles suivantes :

- le système de calcul pour déterminer la position du mobile assure le calcul de l'Atan2 des deux signaux en quadrature comportant le premier harmonique et l'Atan2 des deux signaux en quadrature comportant le deuxième harmonique, ce système de calcul donnant deux positions relatives pour le mobile ;
- le système de calcul calcule le modulo $2\pi$ de la différence entre les deux positions relatives pour le mobile afin d'obtenir la position absolue du mobile ;
- le premier harmonique et le deuxième harmonique présentent respectivement une première fréquence spatiale et une deuxième fréquence spatiale telles que le rapport des fréquences spatiales est donné par la relation suivante: $N_d = \alpha\, N_c \pm 1$, avec $\alpha$ un nombre entier supérieur à 1 ;
- la cible crée un champ magnétique variable de façon continue et comporte le premier et le deuxième harmoniques, l'amplitude ou la direction du champ magnétique étant détectée par les sondes de détection ;
- le système de reconstruction assure une combinaison linéaire des signaux délivrés par les sondes en attribuant des poids de pondération, ces poids de pondération étant programmables de manière à permettre la reconstruction des signaux en quadrature pour un espacement de valeur donnée entre les sondes ;
- les poids de pondération du système de reconstruction sont choisis de manière à obtenir une contribution nulle de la composante homogène du champ magnétique aux signaux reconstruits ;
- la distance maximale entre deux de ses sondes de détection est strictement inférieur à une demi-période de la première fréquence spatiale ;
- toutes les sondes de détection sont regroupés dans un seul circuit intégré microélectronique ;
- au moins deux sondes localisées selon la trajectoire de la cible permettent de mesurer la composante du champ magnétique tangentiel à cette trajectoire et au moins deux sondes localisées selon la trajectoire de la cible permettent de mesurer une composante du champ magnétique perpendiculaire à la trajectoire ;
- la cible comporte deux pistes, chaque piste étant magnétisé avec l'un des deux harmoniques et les sondes de détection sont positionnées sensiblement centrées par rapport aux deux pistes.

Diverses autres caractéristiques ressortent de la description faite ci-dessous en référence aux dessins annexés qui montrent, à titre d'exemples non limitatifs, des formes de réalisation de l'objet de l'invention.

La **Figure 1** représente un capteur selon l'état de l'art antérieur.
La **Figure 2** représente de façon fonctionnelle, un exemple de réalisation d'un capteur de position angulaire selon l'invention.
La **Figure 3** illustre de façon schématique un capteur de position linéaire selon l'invention.
La **Figure 4** représente une forme de réalisation d'une cible aimantée pour un capteur angulaire selon l'invention.
La **Figure 5** illustre un capteur de position angulaire selon l'invention avec des sondes mesurant deux composantes orthogonales du champ magnétique généré par la cible aimantée.

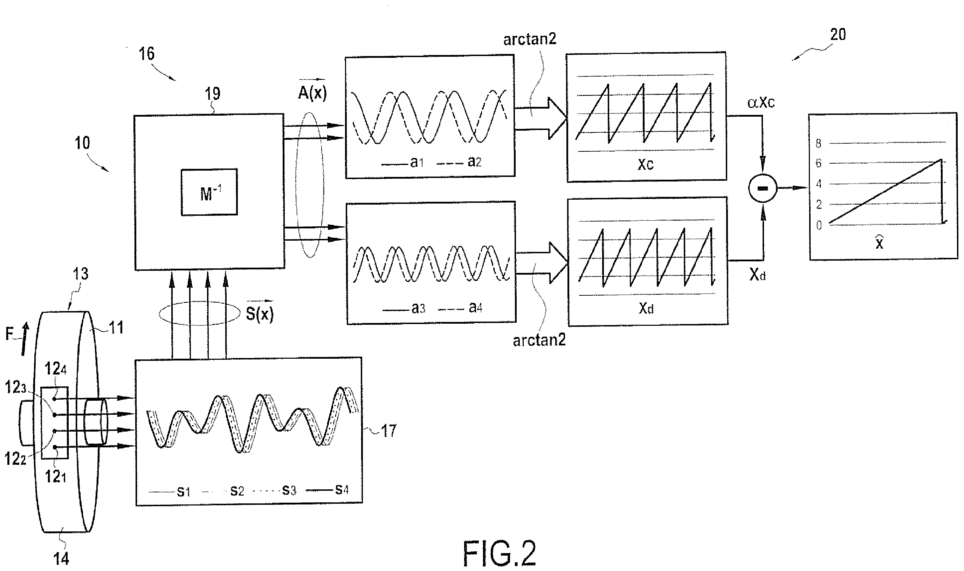

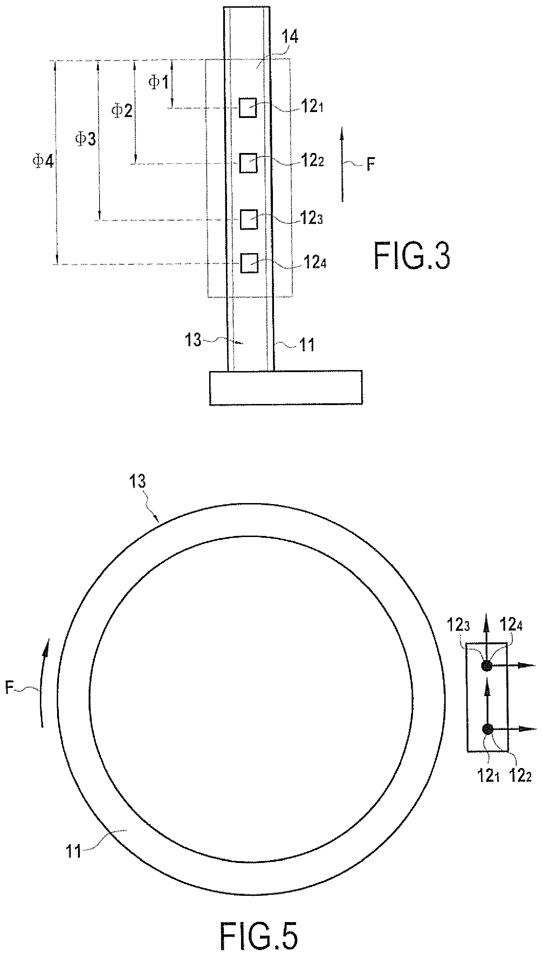

Tel que cela ressort plus précisément de la **Fig. 2**, l'objet de l'invention concerne un capteur de mesure **10** pour déterminer la position d'un mobile **11** se déplaçant selon une trajectoire déterminée représenté par la flèche F. Dans l'exemple illustré à la **Fig. 2**, le mobile **11** se déplace selon une trajectoire circulaire de sorte que le capteur est un capteur de position angulaire. Dans l'exemple illustré à la **Fig. 3**, le mobile **11** se déplace selon une trajectoire rectiligne de sorte que le capteur est un capteur de position linéaire. Bien entendu, le capteur de mesure selon l'invention est apte à déterminer la position d'un mobile comportant une trajectoire différente telle que curviligne.

Le capteur **10** selon l'invention comporte une série d'au moins quatre sondes de détection **12₁, 12₂, 12₃, 12₄**, ..., **12_N** d'une grandeur physique provenant d'une cible **13** montée solidaire du mobile **11**. La cible **13** comporte une piste ou plusieurs pistes **14** pour créer une grandeur physique mesurable par les sondes de détection. Cette grandeur physique mesurable varie selon la trajectoire du mobile selon une fonction continue et comporte un premier harmonique $N_c$ et un deuxième harmonique $N_d$. Selon un exemple préféré de réalisation, la grandeur physique mesurable est un champ magnétique de sorte que le capteur comporte une cible aimantée et des sondes à effet Hall. Bien entendu, la grandeur physique mesurable peut être de nature différente. Ainsi, la cible **13** peut comporter des pistes conductrices de largeur variable et les sondes peuvent être des bobines alimentées en haute fréquence de façon à pouvoir mesurer une variation des inductances en fonction de la largeur de la piste en regard de la bobine dues aux courants de Foucault. Pour simplifier la description, la description détaillée qui suit décrit l'exemple de réalisation avec une cible aimantée et des sondes à effet Hall.

La cible **13** comporte dans l'exemple considéré, une piste aimantée **14**. L'amplitude ou la direction de l'aimantation de la piste varie dans le sens de déplacement de la cible selon une fonction continue et comporte un premier harmonique $N_c$ et un deuxième harmonique $N_d$.

Les sondes de détection **12$_1$**, **12$_2$**, **12$_3$**, **12$_4$**, ..., **12$_N$** sont reliées à une unité **16** de traitement des signaux $s_1$, $s_2$, $s_3$, $s_4$,..., $s_N$ délivrés par les sondes.

Comme cela sera décrit plus en détail dans la suite de la description, cette unité de traitement **16** comporte un système **17** d'acquisition et de traitement des signaux délivrés par les sondes de détection, relié à un système **19** de reconstruction assurant une combinaison linéaire des signaux délivrés par les sondes. Ce système **19** de reconstruction permet d'obtenir à partir de la combinaison linéaire des signaux $s_1$, $s_2$, $s_3$, $s_4$, ..., $s_N$, au moins d'une part, deux signaux en quadrature $a_1$, $a_2$ comportant uniquement le premier harmonique $N_c$ et d'autre part, deux signaux en quadrature $a_3$, $a_4$ comportant uniquement le deuxième harmonique $N_d$. L'unité de traitement **16** comporte également un système de calcul **20** assurant le traitement des signaux en quadrature pour déterminer la position du mobile. Typiquement, ce système de calcul **20** donne deux positions relatives $X_c$, $X_d$ pour le mobile **11** par le calcul de l'Atan2 des deux signaux en quadrature comportant le premier harmonique $N_c$ (à savoir les signaux $a_1$ et $a_2$ dans l'exemple illustré) et l'Atan2 des deux signaux en quadrature comportant le deuxième harmonique $N_d$ (à savoir les signaux $a_3$ et $a_4$ dans l'exemple illustré). Le système de calcul **20** effectue alors le modulo **2n** de la différence entre les deux positions relatives $X_c$, $X_d$ pour le mobile afin d'obtenir la position absolue **x** du mobile.

La description qui suit décrit plus en détail l'unité **16** de traitement des signaux $s_1$, $s_2$, $s_3$, $s_4$,..., $s_N$ délivrés par les sondes. Il doit être considéré que les sondes de détection **12$_1$**, **12$_2$**, **12$_3$**, **12$_4$**, ..., **12$_N$** sont décalées entre elles selon le sens de déplacement de la cible. Le champ magnétique **b** mesuré en un point **x** et selon une direction donnée peut être décrit de la manière suivante:

$$b(x) = V_c \cos(w_c x) + V_d \cos(w_d x)$$

Où $w_c$ = 2n $N_c$/L et $w_d$ = 2n $N_d$/L avec $N_c$ et $N_d$ des nombres entiers correspondant au nombre de périodes de chaque harmonique sur la course **L** de la cible **11** et **x** est la position prise selon la trajectoire. Le premier harmonique présente ainsi une première fréquence spatiale $N_c$ (considéré de basse fréquence par exemple) et le deuxième harmonique présente une deuxième fréquence spatiale $N_d$ (considéré de haute fréquence par exemple). Les paramètres $V_c$ et $V_d$ correspondent à l'amplitude de ces deux harmoniques.

Typiquement, le capteur **1** selon l'invention, réalise simultanément, par le système d'acquisition et de traitement **17**, N mesures $s_k$ du champ magnétique généré par la piste aimantée **14**. Dans l'exemple illustré aux **Fig. 2** et **3**, ces mesures sont réalisées à l'aide des sondes **12$_1$** à **12$_4$** (N=4 dans cet exemple) qui sont décalés entre elles dans le sens de déplacement **F**. Ces différentes mesures $s_k$ sont définies par :

$$s_k(x) = b(x + \phi_k)$$

Où $\phi_k$ correspond à la position de chaque mesure, c'est-à-dire à la position choisie des sondes de détection **12$_1$** à **12$_4$** (**Fig. 3**). Grâce aux formules trigonométriques usuelles, $s_k$ peut être réécrit de la manière suivante :

$$s_k(x) = V_c \cos(w_c \phi_k) \cdot \cos(w_c x) - V_c \sin(w_c \phi_k) \cdot \sin(w_c x)$$
$$+ V_d \cos(w_d \phi_k) \cdot \cos(w_d x) - V_d \sin(w_d \phi_k) \cdot \sin(w_d x)$$

Il est possible de réécrire cette formule sous le format matriciel suivant :

$$\begin{pmatrix} s_1(x) \\ \vdots \\ s_N(x) \end{pmatrix}$$

$$= \begin{pmatrix} V_c\cos(w_c\phi_1) & -V_c\sin(w_c\phi_1) & V_d\cos(w_d\phi_1) & -V_d\sin(w_d\phi_1) \\ \vdots & \vdots & \vdots & \vdots \\ V_c\cos(w_c\phi_N) & -V_c\sin(w_c\phi_N) & V_d\cos(w_d\phi_N) & -V_d\sin(w_d\phi_N) \end{pmatrix} \begin{pmatrix} a_1(x) \\ a_2(x) \\ a_3(x) \\ a_4(x) \end{pmatrix}$$

Où les nouvelles variables $a_p$ sont égales à :

$$\begin{cases} a_1(x) = \cos(w_c x) \\ a_2(x) = \sin(w_c x) \\ a_3(x) = \cos(w_d x) \\ a_4(x) = \sin(w_d x) \end{cases}$$

Formule que l'on peut écrire de manière plus simple à l'aide de la notation matricielle :

$$S(x) = M \cdot A(x)$$

Où S correspond au vecteur colonne Nx1 contenant toutes les mesures $s_k$ dépendant de la position **x** et où **M** est une matrice Nx4 dépendant des positions $\phi_k$ et des périodicités $w_c$ et $w_d$ ou fréquence spatiale $N_c$ et $N_d$. Enfin, **A** est un vecteur 4x1 contenant les variables $a_p$ dépendant de la position **x** de manière plus simple que les variables $s_k$. Comme les relations entre la position **x** et les variables $a_p$ sont plus simples, l'objectif est donc de déterminer ces valeurs $a_p$ à partir des différentes mesures $s_k$. Avec N=4 mesures différentes et si la matrice **M** est de rang plein, les nouvelles variables $a_p$ peuvent être déterminés de la manière suivante en fonction des mesures $s_k$ :

$$A(x) = M^{-1}.S(x)$$

Où $M^{-1}$ est la matrice inverse de la matrice **M** décrit plus haut, et aussi appelée matrice de pondération.
Il est à noter que la matrice de pondération $M^{-1}$ tout comme la matrice **M** dépend uniquement des paramètres fixes et connus du système de mesure, à savoir des positions $\phi_k$ des sondes de détection et des périodicités $w_c$ et $w_d$. Il est donc possible de déterminer, pour un système de mesure donnée, une matrice $M^{-1}$ qui transforme le vecteur **S(x)** de N mesures comportant chacune les deux harmoniques, en un vecteur **A(x)** de quatre signaux $a_1$, $a_2$, $a_3$, $a_4$ dans l'exemple illustré.
Cette matrice $M^{-1}$ défini les poids de pondération appliqués aux signaux $s_1$, $s_2$, $s_3$, $s_4$ par le système de reconstruction **19** afin d'obtenir les signaux $a_1$, $a_2$, $a_3$, $a_4$. Les quatre signaux du vecteur **A(x)** comportent d'une part deux signaux en quadrature $a_1$, $a_2$ comportant uniquement le premier harmonique $N_c$ et d'autre part, deux signaux en quadrature $a_3$, $a_4$ comportant uniquement le deuxième harmonique $N_d$.
En d'autres termes, le système de reconstruction **19** assure une combinaison linéaire des signaux délivrés par les sondes en attribuant des poids de pondération choisis en fonction d'une part, des fréquences spatiales des deux harmoniques et, d'autre part, de la distance entre les sondes de détection.
Ces poids de pondération sont de préférence programmables de manière à permettre la reconstruction des signaux en quadrature pour un espacement de valeur donnée entre les sondes et pour différentes fréquences spatiales. Ainsi, un sous ensemble standard comportant des sondes $12_1$, $12_2$, $12_3$, $12_4$, ..., $12_N$ avec un espacement fixe entre les sondes peut être utilisé pour plusieurs variantes de capteurs avec des cibles de diamètres et de fréquences spatiales diverses.
Dans le cas général où le nombre de mesure N est supérieur à 4, le vecteur **A(x)** peut toujours être déterminé à l'aide de la méthode des moindres carrés:

$$A(x) = (M^T M)^{-1} M^T.S(x)$$

Où $M^T$ est la transposée de la matrice M.

Une fois que le vecteur **A** est déterminé, la détermination de la position **x,** par le système de calcul **20,** se fait très facilement. Dans un premier temps, on calcule d'abord deux positions relatives $X_c$ et $X_d$ :

$$\begin{cases} X_c(x) = atan2\big(a_2(x), a_1(x)\big) = modulo\left(x, \dfrac{L}{N_c}\right) \\ X_d(x) = atan2\big(a_4(x), a_3(x)\big) = modulo\left(x, \dfrac{L}{N_d}\right) \end{cases}$$

Où la fonction atan2 est la fonction qui relie les fonctions sinus et cosinus vers l'angle sur une période de 2n.

Enfin, la position absolue **x** de la cible **13** peut être estimée de la manière suivante :

$$\hat{x} = modulo(X_c - X_d \ , 2\pi)$$

Il est possible d'améliorer ce capteur de telle sorte à ce qu'il annule un champ magnétique extérieur homogène. Pour cela, supposons que le champ total b(x) s'écrive désormais de la manière suivante :

$$b(x) = V_c \cos(w_c x) + V_d \cos(w_d x) + V_e$$

Où $V_e$ est l'amplitude du champ magnétique extérieur homogène. Les mesures $s_k$ s'écrivent désormais de la manière suivante :

$$\begin{pmatrix} s_1(x) \\ \vdots \\ s_N(x) \end{pmatrix}$$

$$= \begin{pmatrix} V_c\cos(w_c\phi_1) & -V_c\sin(w_c\phi_1) & V_d\cos(w_d\phi_1) & -V_d\sin(w_d\phi_1) & 1 \\ \vdots & \vdots & \vdots & \vdots & \vdots \\ V_c\cos(w_c\phi_N) & -V_c\sin(w_c\phi_N) & V_d\cos(w_d\phi_N) & -V\sin(w_d\phi_N) & 1 \end{pmatrix} \begin{pmatrix} a_1(x) \\ a_2(x) \\ a_3(x) \\ a_4(x) \\ V_e \end{pmatrix}$$

La matrice **M** possède désormais une colonne supplémentaire. Par conséquent, il suffit de réaliser N=5 mesures distinctes pour que cette matrice soit de nouveau carrée et inversible. Ainsi, il est possible de déterminer séparément la contribution des variables utiles $a_p$ et du bruit magnétique extérieur $V_e$. Selon cette variante de réalisation, le système de reconstruction **19** permet d'obtenir à partir de la combinaison linéaire des signaux pondérés d'une part, deux signaux en quadrature $a_1$, $a_2$ comportant uniquement le premier harmonique et d'autre part, deux signaux en quadrature $a_3$, $a_4$ comportant uniquement le deuxième harmonique, et un signal $V_e$ comportant uniquement la composante homogène du champ magnétique. Les poids de pondération de ce système de reconstruction **19** permettent d'obtenir une contribution nulle de la composante homogène du champ magnétique aux signaux reconstruits $a_1$, $a_2$, $a_3$, $a_4$.

Tant que toute la chaîne de traitement reste en régime linéaire, les signaux $a_1$, $a_2$, $a_3$, $a_4$ ne sont pas influencés par le champ magnétique homogène et en conséquence la mesure de position n'est pas perturbée par un champ magnétique externe homogène. Dans certaines applications, le champ magnétique externe peut atteindre des valeurs extrêmes provoquant la saturation des sondes magnétiques ou d'une autre partie de la chaîne de traitement, ce qui peut provoquer une mesure erronée. Dans des applications demandant une sureté de fonctionnement importante, il peut donc être utile de valider la position déterminée uniquement si le signal $V_e$ représentant le champ magnétique externe reste dans les limites acceptables, et d'émettre un signal d'alerte dans le cas contraire.

La matrice de pondération $M^{-1}$ est déterminée de façon à complètement supprimer l'harmonique non désiré dans les signaux $a_1(x)$ à $a_N(x)$. Il est possible que cette matrice de pondération apporte en même temps, une atténuation importante à l'harmonique utile, ce qui aura comme conséquence de dégrader le rapport de signal sur bruit, et donc la précision de la mesure. Cette atténuation non désirée dépend de l'espacement entre les points de mesure et des fréquences spatiales utilisées. De manière générale, pour un espacement donnée des points de mesure, une matrice de pondération qui permet d'annuler complètement une fréquence spatiale donnée est susceptible d'atténuer fortement des fréquences spatiales proches. La méthode Vernier classique utilise deux fréquences reliées entre elles selon l'équation :

$$N_d = N_c +/-1$$

Pour obtenir une bonne résolution de mesure, il est souhaitable de choisir des nombres $N_c$ et $N_d$ élevés, et dans ce cas on peut considérer que les fréquences sont proches, et que l'atténuation du signal utile risque d'être importante. Pour remédier à ce problème il est proposé selon une version préféré de l'invention, d'utiliser une relation des deux fréquences spatiales $N_c$, $N_d$ selon l'équation suivante :

$$N_d = \alpha\, N_c \pm 1$$

Avec a un nombre entier supérieur à 1.

Ceci permet d'obtenir un plus grand écart entre les fréquences spatiales utilisées tout en gardant la possibilité de retrouver la position absolue. La position absolue **x** est dans ce cas obtenue à partir des deux positions relatives $X_c$ et $X_d$ selon l'équation suivante :

$$\hat{x} = modulo(\alpha X_c - X_d \;,2\pi)$$

Selon une caractéristique avantageuse de réalisation, la distance maximale entre deux des sondes de détection $12_1$, $12_2$, $12_3$, $12_4$, ..., $12_N$ est strictement inférieur à une demi-période de la première fréquence spatiale $N_c$ à savoir la fréquence la plus basse.

Selon une autre caractéristique avantageuse de réalisation, toutes les sondes de détection $12_1$, $12_2$, $12_3$, $12_4$, ..., $12_N$ sont regroupés dans un seul circuit intégré microélectronique **22**. Un tel avantage est rendu possible par !e fait que toutes les sondes de détection peuvent être montées à proximité les unes des autres. Typiquement, toutes les sondes de détection peuvent être logées dans une surface de l'ordre de quelques mm$^2$.

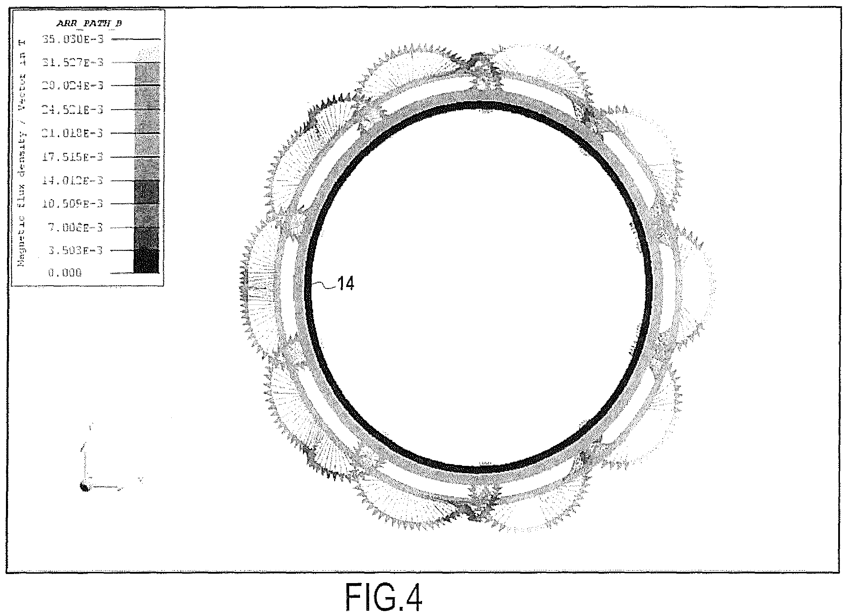

Dans les exemples illustrés aux **Fig. 2** et **3**, la cible **13** comporte une seule piste **14** de création d'une grandeur physique mesurable par les sondes de détection, variant selon la trajectoire de la cible selon une fonction continue et comportant un premier harmonique $N_c$ et un deuxième harmonique $N_d$. La **Fig. 4** illustre un exemple de réalisation d'une cible aimantée **14** comportant une seule piste aimantée. Les flèches montrent la direction et le ton de gris l'intensité du flux magnétique. La réalisation de la cible avec une unique piste contribue à la réalisation d'un capteur de mesure avec un faible encombrement.

Il est à noter que le capteur de mesure selon l'invention peut être mis en oeuvre avec une cible **13** comportant deux pistes **14** montées côte à côte, en étant magnétisé chacune avec l'un des deux harmoniques. Selon une variante préférée de réalisation, les deux pistes **14** sont aménagées pour être accolées alors que les sondes de détection $12_1$, $12_2$, $12_3$, $12_4$, ..., $12_N$ sont positionnées sensiblement centrées par rapport aux deux pistes accolées. En d'autres termes, les sondes de détection $12_1$, $12_2$, $12_3$, $12_4$, ..., $12_N$ sont placées au-dessus de la jonction de ces deux pistes.

La **Fig. 5** montre un autre capteur selon une variante de l'invention. Dans cette variante, au lieu d'utiliser quatre sondes distribuées sur quatre positions décalées dans le sens de mesure, il est utilisé deux paires de sondes $12_1$, $12_2$ et $12_3$, $12_4$, localisées à seulement deux positions différentes dans le sens de déplacement, chaque paire de sondes mesure deux composantes du champ magnétique dans deux directions perpendiculaires dont une composante $b_T$ qui est tangentielle à la trajectoire et une composante $b_P$ qui est perpendiculaire à la trajectoire. Tout d'abord, le champ magnétique autour de la cible peut être approximé de la même manière que précédemment selon deux directions de l'espace :

$$b_P(x) = V_{Pc} \cos(w_c x) + V_{Pd} \cos(w_d x)$$

$$b_T(x) = V_{Tc} \sin(w_c x) + V_{Td} \sin(w_d x)$$

Où $b_P$ et $b_T$ sont deux composantes du champ magnétique perpendiculaires entre elles, et où les coefficients $V_{xx}$ sont des constantes que l'on peut obtenir par simulation ou par mesure. Dans cette variante de l'invention, les quatre mesures $s_k$ sont définies de la manière suivante:

$$s_1(x) = b_P(x + \phi_1)$$

$$s_2(x) = b_P(x + \phi_2)$$

$$s_3(x) = b_T(x + \phi_1)$$

$$s_4(x) = b_T(x + \phi_2)$$

Où $\phi_1$ et $\phi_2$ sont les deux positions de mesures dans cette variante de l'invention. Grâce aux formules trigonométriques usuelles, on peut écrire comme précédemment un système matriciel:

$$\begin{pmatrix} s_1(x) \\ s_2(x) \\ s_3(x) \\ s_4(x) \end{pmatrix}$$

$$= \begin{pmatrix} V_{Pc}\cos(w_c\phi_1) & -V_{Pc}\sin(w_c\phi_1) & V_{Pd}\cos(w_d\phi_1) & -V_{Pd}\sin(w_d\phi_1) \\ V_{Pc}\cos(w_c\phi_2) & -V_{Pc}\sin(w_c\phi_2) & V_{Pd}\cos(w_d\phi_2) & -V_{Pd}\sin(w_d\phi_2) \\ V_{Tc}\sin(w_c\phi_1) & V_{Tc}\cos(w_c\phi_1) & V_{Td}\sin(w_d\phi_1) & V_{Td}\cos(w_d\phi_1) \\ V_{Tc}\sin(w_c\phi_2) & V_{Tc}\cos(w_c\phi_2) & V_{Td}\sin(w_d\phi_2) & V_{Td}\cos(w_d\phi_2) \end{pmatrix} \begin{pmatrix} a_1(x) \\ a_2(x) \\ a_3(x) \\ a_4(x) \end{pmatrix}$$

La démarche est ensuite identique à celle décrite plus haut. Aussi, le champ extérieur peut être annulé de manière similaire en ajoutant une troisième mesure sur la composante $b_P$ et une troisième mesure sur la composante $b_T$.

Il ressort de la description qui précède que les sondes de détection se caractérisent soit par leur emplacement dans l'espace en étant décalées entre elles par rapport à la trajectoire de déplacement du mobile, soit par la composante de la grandeur physique mesurée comme par exemple les composantes radiale ou axial du champ magnétique.

## Revendications

1. Capteur de mesure pour déterminer la position d'un mobile (**11**) se déplaçant selon une trajectoire déterminée F, le capteur comportant une série d'au moins quatre sondes de détection (**12$_1$**, **12$_2$**, **12$_3$**, **12$_4$**, ..., **12$_N$**) d'une grandeur physique provenant d'une cible (**13**) montée solidaire du mobile, la cible comportant au moins une piste (**14**) de création d'une grandeur physique mesurable par les sondes de détection, variant selon la trajectoire de la cible selon une fonction continue et comportant un premier harmonique (**N$_c$**) et un deuxième harmonique (**N$_d$**), les sondes étant reliées à une unité de traitement (**16**) des signaux délivrés par les sondes, comportant un système de reconstruction (**19**), permettant d'assurer une combinaison linéaire des signaux délivrés par les sondes de détection et d'obtenir à partir de la combinaison linéaire de ces signaux, au moins d'une part, deux signaux en quadrature (**a$_1$**, **a$_2$**) comportant uniquement le premier harmonique et d'autre part, deux signaux en quadrature (**a$_3$**, **a$_4$**) comportant uniquement le deuxième harmonique, l'unité comportant également un système de calcul (**20**) assurant le traitement des signaux en quadrature pour déterminer la position du mobile.

2. Capteur de mesure selon la revendication 1, **caractérisé en ce que** le système de calcul (**20**) pour déterminer la position du mobile assure le calcul de l'Atan2 des deux signaux en quadrature comportant le premier harmonique et l'Atan2 des deux signaux en quadrature comportant le deuxième harmonique, ce système de calcul donnant deux positions relatives pour le mobile.

3. Capteur de mesure selon l'une des revendications 1 ou 2, **caractérisé en ce que** le système de calcul (**20**) calcule le modulo $2\pi$ de la différence entre les deux positions relatives pour le mobile afin d'obtenir la position absolue ($\hat{x}$) du mobile.

4. Capteur de mesure selon l'une des revendications 1 à 3, **caractérisé en ce que** le premier harmonique et le deuxième harmonique présentent respectivement une première fréquence spatiale ($N_c$) et une deuxième fréquence spatiale ($N_d$) telles que le rapport des fréquences spatiales est donné par la relation suivante: $N_d = \alpha N_c \pm 1$, avec $\alpha$ un nombre entier supérieur à 1.

5. Capteur de mesure selon la revendication 1, **caractérisé en ce que** la cible (**13**) crée un champ magnétique variable de façon continue et comporte le premier et le deuxième harmoniques, l'amplitude ou la direction du champ magnétique étant détectée par les sondes de détection.

6. Capteur de mesure selon la revendication 1, **caractérisé en ce que** le système de reconstruction (**19**) assure une combinaison linéaire des signaux délivrés par les sondes en attribuant des poids de pondération, ces poids de pondération étant programmables de manière à permettre la reconstruction des signaux en quadrature pour un espacement de valeur donnée entre les sondes.

7. Capteur de mesure selon l'une des revendications 1 à 6, **caractérisé en ce que** les poids de pondération du système de reconstruction (**19**) sont choisis de manière à obtenir une contribution nulle de la composante homogène du champ magnétique aux signaux reconstruits ($a_1$, $a_2$, $a_3$, $a_4$).

8. Capteur de mesure selon la revendication **1**, **caractérisé en ce que** la distance maximale entre deux de ses sondes de détection ($12_1$, $12_2$, $12_3$, $12_4$, ..., $12_N$) est strictement inférieur à une demi-période de la première fréquence spatiale ($N_c$).

9. Capteur de mesure selon l'une des revendications 1 à 8, **caractérisé en ce que** toutes les sondes de détection ($12_1$, $12_2$, $12_3$, $12_4$, ..., $12_N$) sont regroupés dans un seul circuit intégré microélectronique.

10. Capteur de mesure selon l'une des revendications 1 à 9, **caractérisé en ce qu'**il comporte au moins deux sondes ($12_1$, $12_2$) localisées selon la trajectoire de la cible permettant de mesurer la composante du champ magnétique tangentiel à cette trajectoire et au moins deux sondes ($12_3$, $12_4$) localisées selon la trajectoire de la cible permettant de mesurer une composante du champ magnétique perpendiculaire à la trajectoire.

11. Capteur de mesure selon l'une des revendications 1 à 10, **caractérisé en ce que** la cible (**13**) comporte deux pistes (**14**), chaque piste étant magnétisé avec l'un des deux harmoniques et **en ce que** les sondes de détection ($12_1$, $12_2$, $12_3$, $12_4$, ..., $12_N$) sont positionnées sensiblement centrées par rapport aux deux pistes.

**Patentansprüche**

1. Messsensor zum Bestimmen der Position eines sich bewegenden Körpers (11), der sich gemäß einer bestimmten Bahn F bewegt, wobei der Sensor eine Reihe von mindestens vier Sonden ($12_1$, $12_2$, $12_3$, $12_4$, ..., $12_N$) zur Erfassung einer physikalischen Größe umfasst, die von einem Ziel (13) ausgeht, das an dem sich bewegenden Körper fest montiert ist, wobei das Ziel mindestens eine Spur (14) zur Erzeugung einer physikalischen Größe umfasst, die durch die Erfassungssonden messbar ist, gemäß der Bahn des Ziels gemäß einer kontinuierlichen Funktion variiert und eine erste Oberwelle ($N_c$) und eine zweite Oberwelle ($N_d$) umfasst, wobei die Sonden mit einer Einheit (16) zur Verarbeitung von durch die Sonden abgegebenen Signalen verbunden sind, die ein Rekonstruktionssystem (19) umfasst, das ermöglicht, eine Linearkombination von durch die Erfassungssonden abgegebenen Signalen sicherzustellen und aus der Linearkombination dieser Signale mindestens einerseits zwei Quadratursignale ($a_1$, $a_2$), die einzig die erste Oberwelle umfassen, und andererseits zwei Quadratursignale ($a_3$, $a_4$), die einzig die zweite Oberwelle umfassen, zu erhalten, wobei die Einheit außerdem ein Berechnungssystem (20) umfasst, das die Verarbeitung von Quadratursignalen zum Bestimmen der Position des sich bewegenden Körpers sicherstellt.

2. Messsensor nach Anspruch 1, **dadurch gekennzeichnet, dass** das Berechnungssystem (20) zum Bestimmen der Position des sich bewegenden Körpers die Berechnung der atan2 von zwei Quadratursignalen, die die erste Oberwelle umfassen, und der atan2 von zwei Quadratursignalen, die die zweite Oberwelle umfassen, sicherstellt, wobei dieses Berechnungssystem zwei relative Positionen für den sich bewegenden Körper angibt.

3. Messsensor nach einem der Ansprüche 1 oder 2, **dadurch gekennzeichnet, dass** das Berechnungssystem (20) das Modulo $2\pi$ der Differenz zwischen den zwei relativen Positionen für den sich bewegenden Körper berechnet, um die absolute Position ($\hat{x}$) des sich bewegenden Körpers zu erhalten.

**4.** Messsensor nach einem der Ansprüche 1 bis 3, **dadurch gekennzeichnet, dass** die erste Oberwelle und die zweite Oberwelle eine erste Raumfrequenz ($N_c$) bzw. eine zweite Raumfrequenz ($N_d$) aufweisen, so dass das Verhältnis von Raumfrequenzen durch die folgende Gleichung angegeben wird: $N_d = \alpha \times N_c \pm 1$, wobei $\alpha$ eine ganze Zahl größer als 1 ist.

**5.** Messsensor nach Anspruch 1, **dadurch gekennzeichnet, dass** das Ziel (13) ein Magnetfeld erzeugt, das kontinuierlich variabel ist und die erste und die zweite Oberwelle umfasst, wobei die Amplitude oder die Richtung des Magnetfelds von den Erfassungssonden erfasst wird.

**6.** Messsensor nach Anspruch 1, **dadurch gekennzeichnet, dass** das Rekonstruktionssystem (19) eine Linearkombination von durch die Sonden abgegebenen Signalen durch Zuweisen von Gewichtungsgewichten sicherstellt, wobei diese Gewichtungsgewichte derart programmierbar sind, dass die Rekonstruktion von Quadratursignalen für einen Abstand eines gegebenen Werts zwischen den Sonden ermöglicht wird.

**7.** Messsensor nach einem der Ansprüche 1 bis 6, **dadurch gekennzeichnet, dass** die Gewichtungsgewichte des Rekonstruktionssystems (19) derart ausgewählt werden, dass ein Nullbeitrag der homogenen Komponente des Magnetfelds zu den rekonstruierten Signalen ($a_1$, $a_2$, $a_3$, $a_4$) erhalten wird.

**8.** Messsensor nach Anspruch 1, **dadurch gekennzeichnet, dass** die maximale Entfernung zwischen zwei seiner Erfassungssonden ($12_1$, $12_2$, $12_3$, $12_4$, ..., $12_N$) strikt kleiner als eine Halbperiode der ersten Raumfrequenz ($N_c$) ist.

**9.** Messsensor nach einem der Ansprüche 1 bis 8, **dadurch gekennzeichnet, dass** alle Erfassungssonden ($12_1$, $12_2$, $12_3$, $12_4$, ..., $12_N$) in einer einzigen mikroelektronischen integrierten Schaltung zusammengruppiert sind.

**10.** Messsensor nach einem der Ansprüche 1 bis 9, **dadurch gekennzeichnet, dass** er mindestens zwei Sonden ($12_1$, $12_2$), die gemäß der Bahn des Ziels angeordnet sind, was ermöglicht, die Komponente des Magnetfelds zu messen, die tangential zu dieser Bahn ist, und mindestens zwei Sonden ($12_3$, $12_4$) umfasst, die gemäß der Bahn des Ziels angeordnet sind, was ermöglicht, eine Komponente des Magnetfelds zu messen, die senkrecht zu der Bahn ist.

**11.** Messsensor nach einem der Ansprüche 1 bis 10, **dadurch gekennzeichnet, dass** das Ziel (13) zwei Spuren (14) umfasst, wobei jede Spur mit einer von zwei Oberwellen magnetisiert ist, und dass die Erfassungssonden ($12_1$, $12_2$, $12_3$, $12_4$, ..., $12_N$) in Bezug auf die zwei Spuren im Wesentlichen zentriert positioniert sind.

**Claims**

**1.** A measurement sensor for determining the position of a moving body (11) moving along a determined path F, the sensor comprising a series of at least four detector probes ($12_1$, $12_2$, $12_3$, $12_4$, ..., $12_N$) for detecting a physical magnitude coming from a target (13) securely mounted on the moving body, the target comprising at least one track (14) for creating a physical magnitude that is measurable by the detector probes and that varies along the path of the target with a function that is continuous and that includes a first harmonic ($N_c$) and a second harmonic ($N_d$), the probes being connected to a processor unit (16) for processing signals delivered by the probes, the processor unit including a reconstruction system (19) for performing a linear combination of the signals delivered by the detector probes and for obtaining from the liner combination of those signals at least firstly two quadrature signals ($a_1$, $a_2$) including solely the first harmonic, and secondly two quadrature signals ($a_3$, $a_4$) including solely the second harmonic, the unit also including a calculation system (20) for processing the quadrature signals in order to determine the position of the moving body.

**2.** A measurement sensor according to claim 1, **characterized in that** the calculation system (20) for determining the position of the moving body calculates the Atan2 of the two quadrature signals including the first harmonic and the Atan2 of the two quadrature signals including the second harmonic, the calculation system giving two relative positions for the moving body.

**3.** A measurement sensor according to claim 1 or claim 2, **characterized in that** the calculation system (20) calculates the difference between the two relative positions for the moving body modulo $2\phi$ in order to obtain the absolute position ($\hat{x}$) of the moving body.

**4.** A measurement sensor according to any one of claims 1 to 3, **characterized in that** the first harmonic and the second harmonic present respectively a first spatial frequency ($N_c$) and a second spatial frequency ($N_d$) such that the ratio of the spatial frequencies is given by the following relationship;
$N_d = \alpha N_c \pm 1$ where $\alpha$ is an integer greater than 1.

5. A measurement sensor according to claim 1, **characterized in that** the target (13) creates a magnetic field that varies continuously and that includes the first and second harmonics, the amplitude or the direction of the magnetic field being detected by the detector probes.

6. A measurement sensor according to claim 1, **characterized in that** the reconstruction system (19) performs a linear combination of the signals delivered by the probes by applying weighting weights, these weighting weights being programmable in such a manner as to enable the quadrature signals to be reconstructed for a spacing of given value between the probes.

7. A measurement sensor according to any one of claims 1 to 6, **characterized in that** the weighting weights of the reconstruction system (19) are selected so as to obtain a zero contribution from the uniform component of the magnetic field to the reconstructed signals ($a_1$, $a_2$, $a_3$, $a_4$).

8. A measurement sensor according to claim 1, **characterized in that** the maximum distance between two of its detector probes ($12_1$, $12_2$, $12_3$, $12_4$, ..., $12_N$) is strictly less than one half-period of the first spatial frequency ($N_c$).

9. A measurement sensor according to any one of claims 1 to 8, **characterized in that** all of the detector probes ($12_1$, $12_2$, $12_3$, $12_4$, ..., $12_N$) are grouped together in a single microelectronic integrated circuit.

10. A measurement sensor according to any one of claims 1 to 9, **characterized in that** it includes at least two probes ($12_1$, $12_2$) located on the path of the target that enable the component of the magnetic field that is tangential to the path to be measured, and at least two probes ($12_3$, $12_4$) located along the path of the target that enable a component of the magnetic field that is perpendicular to the path to be measured.

11. A measurement sensor according to any one of claims 1 to 10, **characterized in that** the target (13) has two tracks (14), each track being magnetized with one of the two harmonics, and **in that** the detector probes ($12_1$, $12_2$, $12_3$, $12_4$, ..., $12_N$) are positioned substantially centered relative to the two tracks.

FIG.1

FIG.2

FIG.3

FIG.5

EP 3 325 922 B1

FIG.4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 01142753 A
- WO 2014131434 A
- EP 2385353 A
- US 2008024122 A